# EUROPÄISCHE PATENTANMELDUNG

(11) **EP 4 086 704 A1**
(43) Veröffentlichungstag der Anmeldung: **09.11.2022**
(21) Anmeldenummer: 22171915.6
(22) Anmeldetag: 05.05.2022
(51) Int. Cl.: G03F 7/20, G03F 7/12

(54) **VERFAHREN ZUR HERSTELLUNG EINER LOCHBLENDE, LOCHBLENDE SOWIE VERWENDUNG EINER LOCHBLENDE IN EINEM OPTISCHEN AUFBAU**

(30) Priorität: 06.05.2021 DE 102021111787
(71) Anmelder: AMO GmbH, 52074 Aachen (DE)
(72) Erfinder: MÖLLER, Michael, 52066 Aachen (DE); BOLTEN, Jens, 52064 Aachen (DE); CAPRARO, Giovanna, 52064 Aachen (DE); PASSI, Vikram, 52064 Aachen (DE)
(74) Vertreter: Patentanwälte Bauer Vorberg Kayser

(57) **Zusammenfassung**

Die Erfindung betrifft ein Verfahren zur Herstellung einer Lochblende (300), die zur Strahlformung und/oder zur räumlichen Filterung von Strahlung, insbesondere Laserstrahlung, geeignet ist. Ferner betrifft die Erfindung eine nach dem genannten Verfahren hergestellte Lochblende (300). Die erwähnte Lochblende (300) kann zudem in einer Anordnung (400) aus einer Mehrzahl von Lochblenden (300) in Form eines Lochblenden-Arrays zum Einsatz kommen. Weiterhin stellt die Erfindung auf eine Verwendung der genannten Lochblende (300) bzw. der Anordnung (400) aus einer Mehrzahl von Lochblenden (300) in einem optischen Aufbau ab, insbesondere einem Interferometrie- oder Holographie-Aufbau.

Die Erfindung stellt ein vereinfachtes Verfahren zur Herstellung einer zur Strahlformung und/oder zur räumlichen Filterung von Strahlung, insbesondere Laserstrahlung, geeigneten Lochblende (300) bereit. Ferner gibt die Erfindung eine Lochblende (300) sowie eine Anordnung aus einer Mehrzahl von Lochblenden (300) zu einem Lochblenden-Array an, die sich auf vereinfachte Weise fertigen lassen und vielseitig anwendbar sind. Letztlich gibt die Erfindung eine Verwendung einer Lochblende (300) oder Anordnung (400) einer Mehrzahl von Lochblenden (300) an, die eine optimierte Strahlformung und gleichzeitig eine räumliche Filterung von Strahlung, insbesondere Laserstrahlung, in einem optischen Aufbau erlaubt.

## Beschreibung

Die vorliegende Erfindung betrifft zunächst ein Verfahren zur Herstellung einer Lochblende, die zur Strahlformung und/oder zur räumlichen Filterung von Strahlung, insbesondere Laserstrahlung, geeignet ist. Ferner betrifft die vorliegende Erfindung eine nach dem genannten Verfahren hergestellte Lochblende. Die erwähnte Lochblende kann zudem in einer Anordnung aus einer Mehrzahl von Lochblenden in Form eines Lochblenden-Arrays zum Einsatz kommen, was ebenfalls Gegenstand der vorliegenden Erfindung ist. Weiterhin stellt die vorliegende Erfindung auf eine Verwendung der genannten Lochblende bzw. der Anordnung aus einer Mehrzahl von Lochblenden in einem optischen Aufbau ab, insbesondere einem Interferometrie- oder Holographie-Aufbau.

Aufgrund der fortschreitenden Entwicklung der Lasertechnik und des zunehmenden Einsatzes derselbigen im Bereich der Werkstückbearbeitung, besteht ein wachsendes Interesse an einer Verbesserung der Bearbeitungsqualität, Bearbeitungsgeschwindigkeit und Präzision. Beispielhaft (aber nicht abschließend) seien die folgenden auf Laserstrahlung beruhenden Bearbeitungsverfahren genannt: Laserschneiden, Laserschweißen, Laserlöten, Laserreinigen, Laserbohren, Lasersintern, Laserschmelzen. Ein ähnliches Optimierungsbestreben gilt im Grund auch für die Bereiche der optischen Mess- oder Projektionstechnik, in welchen Laser ebenfalls zunehmend eingesetzt werden.

Bei der Materialbearbeitung mit Laserstrahlung wird aktuell meist Laserstrahlung mit einer gaußförmigen Intensitätsverteilung (Strahlprofil) eingesetzt. Laserstrahlung mit einem derartigen Strahlprofil wird auch als TEM00 Mode bezeichnet. Für viele dieser Prozesse ist es jedoch erstrebenswert, die Intensitätsverteilung (also das Strahlprofil) an den konkret vorliegenden Bearbeitungsprozess bzw. das zu bearbeitende Material anzupassen. Daher werden zunehmend Optimierungen der Laserverfahren durch Änderung der Intensitätsverteilung bzw. Anpassung der Strahlform untersucht. Zur Anpassung der Intensitätsverteilung ist es dabei bekannt, die von einer Laserstrahlungsquelle erzeugte Laserstrahlung einer Strahlformung zu unterziehen, was ein erhebliches Optimierungspotenzial für die Laserprozessentwicklung bietet.

Wie bereits erwähnt, weist die von einer Laserstrahlungsquelle erzeugte Laserstrahlung in Bezug auf ihren Strahlenquerschnitt typischerweise eine gaußförmige Intensitätsverteilung bzw. ein gaußförmiges Strahlprofil auf. Über geeignete Strahlformungstechniken können Laserstrahlen jedoch unter Abänderung der Intensitätsverteilung geformt werden. Zur Formung einer Intensitätsverteilung eines Laserstrahls können entweder seine Phase, seine Amplitude oder beide Größen zusammen moduliert werden. Entsprechend kommen Phasenmodulatoren, Amplitudenmodulatoren oder Phasen- und Amplitudenmodulatoren zum Einsatz, beispielsweise in Form von diffraktiven Strahlformern. Diffraktive Strahlformer (Diffractive Optical Elements, kurz DOE) zur Einstellung von Fernfeldintensitäten können als Phasenelemente in Glas oder anderen transparenten Materialien hergestellt werden.

Weiterhin kann die Form einer Intensitätsverteilung durch Brechung und Reflektion an optischen Elementen erfolgen. Entsprechend kommen geformte refraktive oder reflektive Elemente wie beispielsweise deformierte oder deformierbare Spiegel oder transmissive Elemente mit einer geometrischen Verformung der Oberfläche oder Form zum Einsatz. Die einzelnen Teilstrahlen eines auf das refraktive oder reflektive optische Element einfallenden Laserstrahls, fallen dabei auf jeweils unterschiedlich gewölbte Oberflächen und werden an diesen reflektiert oder gebrochen. Die Gesamtheit der Teilstrahlen bildet nach der Formung durch das Element eine neue Intensitätsverteilung. Ein Beispiel für ein solche Strahlformung ist die Umformung eines gaußförmigen Laserstrahls in einen Top-Hat förmigen Laserstrahl, auch Gauß-zu-Top-Hat Strahlformer genannt. Die für die Strahlformung notwendige geometrische Verformung der Oberfläche kann mit analytischen, numerischen oder iterativen Verfahren (z.B. Überlagerung von Zernikepolynomen) berechnet werden.

Diffraktive strahlformende Elemente können jedoch auch als Strahlteiler ausgebildet sein. Beispielhaft seien in diesem Zusammenhang binäre Gitter oder Blazed Gratings genannt. Aufgrund der Geometrie der diffraktiven Struktur kommt es auf einem rechteckigen Gitter im Ortsfrequenzraum (k-Raum) zu konstruktiver Interferenz. Durch numerische Algorithmen können unterschiedlichste Anordnungen von aktiven Beugungsordnungen (konstruktive Interferenz) verwirklicht werden. Hierbei muss die Winkeltrennung der Beugungsordnungen groß genug gegenüber der Fernfelddivergenz der einfallenden Laserstrahlung sein, da andernfalls Interferenz die Anordnung der aktiven Beugungsordnungen stört.

Solche unveränderbaren DOEs werden jedoch zunehmend durch programmierbare Modulationseinheiten zur dynamischen Formung der Laserstrahlung ersetzt. Mit programmierbaren Modulationseinheiten kann die örtliche und zeitliche Intensitätsverteilung von seitens einer Laserstrahlungsquelle ausgesendeten Laserstrahlung eingestellt werden. Derart programmierbare Modulationseinheiten werden auch als "Spatial Light Modulator (SLM)" bezeichnet.

Strahlformungstechniken, bei denen bestimmte homogene oder inhomogene Strahlanteile im expandierten Strahl ausgeblendet werden, können nachteilig sein, da ein Großteil der bereitgestellten Strahlungsenergie ausgeblendet wird und nur ein Bruchteil der auf die Lochblende einfallenden Energie zur homogenen Ausleuchtung zur Verfügung steht.

Umfasst die Strahlformungstechnik Bauelemente mit im Strahlengang angeordneten optische Flächen, so können diese beispielsweise aufgrund einer Anhaftung von Staubpartikeln - bei Verwendung von kohärenten Laserlicht - zufällige Beugungsmuster in der Belichtungsebene erzeugen. Diese können die homogen ausgeleuchtete Fläche störend überlagern und somit für Anwendungen im Bereich der Holographie oder der Lithographie störend sind. Eine räumliche Filterung ist sodann nicht ermöglicht.

Wie erwähnt, weist ein Laserstrahl im TEM00 Mode in der Regel ein gaußförmiges Strahlprofil auf. Ferner weisen derartige Laserstrahlen meist einen Strahldurchmesser von wenigen Millimetern auf. Soll eine große Fläche (z.B. eines zu bearbeitenden Werkstücks) mit Laserstrahlung ausgeleuchtet werden, so ist es bekannt, den Strahl mit Hilfe eines Objektivs aufzuweiten. Durch Platzierung einer Lochblende als "spatial filter" (= räumlicher Filter) im Fokus des Objektivs, können zufällige (ungewünschte) Beugungsmuster eliminiert werden. Letztere können beispielsweise durch Streulicht entstehen.

Die Strahlungsintensität fällt quer zur optischen Strahlachse des aufgeweiteten Strahls relativ schnell ab, nämlich entsprechend der Beugungsfigur der verwendeten Lochblende. Um eine größere Fläche hinreichend homogen mit Laserstrahlung beleuchten zu können, muss entweder der Durchmesser der Lochblende verkleinert, oder die Entfernung zum zu bestrahlten Objekt vergrößert werden. Beide Varianten gehen mit einem Intensitätsverlust einher und sind daher nicht bevorzugt.

Aus dem Stand der Technik, vgl. die Publikation *"*Modifed pinhole spatial filter producing a clean flat-topped beam", in Optics & Laser Technology, by P. Hariharan, Andal Narayanan, 2003*",* ist es bekannt Lochblenden mit einer ringförmigen Phasenmaske zu versehen, wodurch eine größere Fläche homogen bestrahlt werden kann. Gleichzeitig ist der Strahl sodann räumlich gefiltert und frei von störenden, zufälligen Beugungsmustern. Die Kombination von Lochblenden mit ringförmigen Phasenmasken ermöglicht einerseits die Strahlformung eines Laserstrahls und andererseits eine räumliche Filterung. Es hat sich herausgestellt, dass ein solche Kombination effizienter ist als die Benutzung von Standard-Lochblenden (Aperturen) mit kleinem Durchmesser oder die Vergrößerung des Arbeitsabstandes von der Lochblende zur Belichtungsebene.

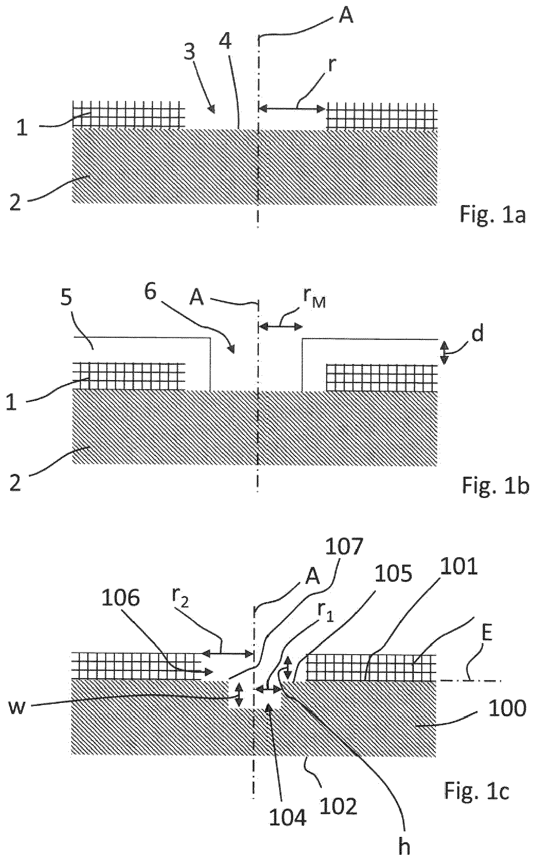

In der genannten Publikation von Hariharan et al. ist eine Lochblende mit einer komplexen, radial variierende Amplitudentransmissionsfunktion (siehe die dortige Abb. 1) theoretisch beschrieben. Umgesetzt wurde dies durch die Kombination einer Apertur in einer opaken Metallfolie und einer dazu zentrierten Phasenmaske. Eine solche Lochblende kann - wie dort beschrieben - in einem zweistufigen Fertigungsprozess hergestellt werden. Zunächst wird dazu eine opake Metallfolie auf einem Substrat aufgebracht, wobei eine Öffnung in die Metallfolie hineingeätzt wird. Die Öffnung kennzeichnet sich durch einen Radius r in Bezug auf eine sich zentriert entlang der Öffnung erstreckende Achse. In einem zweiten Schritt wird ein transparenter Film einer Schichtdicke d auf das Substrat (bzw. die opake Metallfolie) aufgebracht. In den transparenten Film wird eine in Bezug auf die erwähnte Achse konzentrische Öffnung geätzt, wobei die Öffnung des transparenten Films einen Radius r_{M} aufweist, der geringer ist als der Radius r.

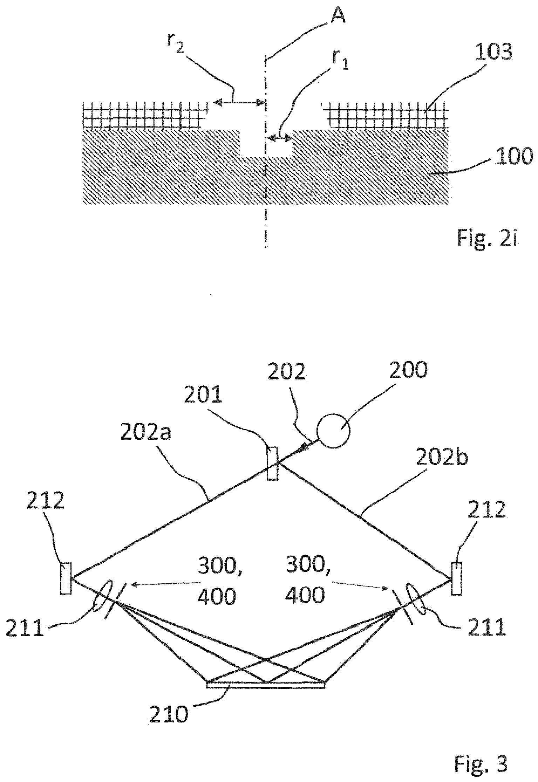

Bei geeigneter Wahl der Durchmesser r und r_{M}, und einer angepassten Schichtdicke d des transparenten Films, zeigt die Beugungsfigur in der Belichtungsebene einen starken Homogenisierungseffekt, siehe Abb. 3 der dortigen Publikation.

Der von Hariharan et al. beschriebene Lochblende lässt sich mit in der Halbleiterindustrie gebräuchlichen Mitteln zur Erzeugung von Mikro- und Nanostrukturen nur recht schwer herstellen.

Entsprechend liegt der vorliegenden Erfindung die Aufgabe zu Grunde ein vereinfachtes Verfahren zur Herstellung einer zur Strahlformung und/oder zur räumlichen Filterung von Strahlung, insbesondere Laserstrahlung, geeigneten Lochblende bereitzustellen. Ferner liegt der Erfindung die Aufgabe zu Grunde eine Lochblende sowie eine Anordnung aus einer Mehrzahl von Lochblenden zu einem Lochblenden-Array anzugeben, die sich auf vereinfachte Weise fertigen lassen und vielseitig anwendbar sind. Letztlich liegt der Erfindung die Aufgabe zugrunde, eine Verwendung einer Lochblende oder Anordnung einer Mehrzahl von Lochblenden anzugeben, die eine optimierte Strahlformung und gleichzeitig eine räumliche Filterung von Strahlung, insbesondere Laserstrahlung, in einem optischen Aufbau erlaubt.

Gelöst wird die Aufgabe durch ein Verfahren gemäß dem Anspruch 1, eine Lochblende gemäß dem Anspruch 11, einer Anordnung aus einer Mehrzahl von Lochblenden gemäß dem Anspruch 13 sowie einer Verwendung gemäß dem Anspruch 14.

Es ist darauf hinzuweisen, dass die in den Ansprüchen einzeln aufgeführten Merkmale in beliebiger, technisch sinnvoller Weise miteinander kombiniert werden können (auch über Kategoriegrenzen hinweg) und weitere Ausgestaltungen der Erfindung aufzeigen. Die Beschreibung charakterisiert und spezifiziert die Erfindung insbesondere im Zusammenhang mit den Figuren zusätzlich.

Es sei ferner darauf hingewiesen, dass eine hierin verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Zunächst betrifft die Erfindung ein Verfahren zur Herstellung einer Lochblende, die zur Strahlformung und/oder zur räumlichen Filterung von Strahlung, insbesondere Laserstrahlung, geeignet ist, umfassend die folgenden Schritte:
a. Bereitstellen eines transparenten Substrats, wobei das transparente Substrat eine erste Substratoberfläche und eine der ersten Substratoberfläche gegenüberliegende zweite Substratoberfläche aufweist;
b. Abscheiden einer strahlungsundurchlässigen Schicht auf der ersten Substratoberfläche;
c. Auftragen einer lithographisch bearbeitbaren Schicht auf der strahlungsundurchlässigen Schicht;
d. Partielles Freilegen eines ersten Teilbereichs der ersten Substratoberfläche durch
   - Lithographisches Abtragen der lithographisch bearbeitbaren Schicht in einem ersten Abtragungsbereich und darauffolgendes
   - Abtragen der strahlungsundurchlässigen Schicht in einem in Richtung der ersten Substratoberfläche an den ersten Abtragungsbereich angrenzenden zweiten Abtragungsbereich;
e. Aufbringen einer lithographisch bearbeitbaren Auftragsmasse in dem freigelegten ersten Teilbereich;
f. Partielles Freilegen eines zweiten Teilbereichs der ersten Substratoberfläche, wobei der zweite Teilbereich bezogen auf eine mit der ersten Substratoberfläche zusammenfallenden Substratebene innerhalb eines gedachten ersten Teilbereichs liegt, wobei das Freilegen durch teilweises lithographisches Abtragen der lithographisch bearbeitbaren Auftragsmasse erfolgt;
g. Ausgehend von dem freigelegten zweiten Teilbereich der ersten Substratoberfläche: Abtragen des transparenten Substrats in einem Substrat-Abtragungsbereich zur Ausbildung einer zylindrischen Lochöffnung, wobei die Lochöffnung in ihrer lateralen Ausdehnung dem zweiten Teilbereich entspricht und sich in Richtung der zweiten Substratoberfläche über eine Teildicke des transparenten Substrats erstreckt;
h. Entfernen von Resten der lithographisch bearbeitbaren Schicht und/oder der lithographisch bearbeitbaren Auftragsmasse.

Der Terminus "Bereitstellen" ist breit auszulegen, denn damit kann einerseits eine unkörperliche Bedeutung verbunden sein, beispielsweise im Sinne von "Verwenden" eines transparenten Glassubstrats, andererseits aber auch ein körperlicher Verfahrensschritt im Sinne von "Vorlegen oder Aufnehmen eines transparenten Substrats" in einer Aufnahmeeinheit (z.B. einer Fertigungseinrichtung).

Bei dem Substrat handelt es sich vorzugsweise um ein plattenförmiges Substrat, d.h. die erste und zweite Substratoberfläche sind planparallel. Gleichsam kann vorgesehen sein, dass das Substrat (und damit auch die erste und/oder zweite Substratoberfläche) eine von der beschriebenen "Plattenform" abweichende Form aufweist. So können die Substratoberfläche beispielsweise eine Krümmung aufweisen, also konvex oder konkav gekrümmt sein. Die Grundform des Substrats kann polygonal (z.B. dreieckig, viereckig in Form eines Quadrats oder Rechtecks), kreisförmig (scheibenförmig), oval, elliptisch oder dergleichen sein.

Unter einer "strahlungsundurchlässigen Schicht" kann eine jede Schicht oder Beschichtung verstanden werden (sei diese ein- oder mehrlagig), die eine Transmission (Hindurchtreten) von Strahlung einer bestimmten Wellenlänge verhindert (z.B. kann die strahlungsundurchlässige Schicht undurchlässig, also optisch opak, für Laserstrahlung vorgegebener Wellenlänge sein). Die Schicht kann beispielsweise absorbierend oder optional reflektierend ausgebildet sein. Die Strahlungsundurchlässigkeit bezieht sich auf jene Strahlung, die in einem optischen Aufbau durch die zu fertigende Lochblende räumlich gefiltert oder geformt werden soll. Die strahlungsundurchlässige Schicht kann als "Beam Blocking" Einheit verstanden werden. Beispielsweise kann strahlungsundurchlässige Schicht undurchlässig für Laserstrahlung sein. Alternativ oder zusätzlich zum Abscheiden der strahlungsundurchlässigen Schicht auf der ersten Substratoberfläche kann eine strahlungsundurchlässige Schicht auch auf der gegenüberliegenden zweiten Substratoberfläche abgeschieden werden. Die erste Substratoberfläche (und optional die zweite Substratoberfläche) kann vollständig oder partiell mit der strahlungsundurchlässigen Schicht beaufschlagt werden. Unter einem "Abscheiden" kann zunächst jegliches Verfahren verstanden werden, das zum Beaufschlagen einer Substratoberfläche mit der strahlungsundurchlässigen Schicht geeignet ist.

Im Verfahrensschritt c. wird eine lithographisch bearbeitbare Schicht auf der strahlungsundurchlässigen Schicht aufgetragen. Unter "Auftragen" kann jegliches Auftragungsverfahren verstanden werden, das zum Auftragen oder Aufbringen einer lithographisch bearbeitbaren Schicht auf einen Träger (hier die strahlungsundurchlässige Schicht). Zur Vereinfachung kann vorzugsweise die gesamte strahlungsundurchlässige Schicht mit der lithographisch bearbeitbaren Schicht beaufschlagt werden, gleichsam kann nur ein Teil der Oberfläche der strahlungsundurchlässigen Schicht mit der lithographisch bearbeitbaren Schicht beaufschlagt werden. Der Terminus "lithographisch bearbeitbar" bedeutet vorliegend, dass die aufgetragene lithographisch bearbeitbare Schicht durch Bestrahlen mit Strahlung geeigneter Wellenlänge und Intensität bearbeitet werden kann. Beispielsweise kann unter einer "Bearbeitung" in diesem Zusammenhang eine Veränderung der Löslichkeit der lithographisch bearbeitbaren Schicht verstanden werden, wodurch bearbeitete Teile der lithographisch bearbeitbaren Schicht abgelöst bzw. entfernt werden können. Auch können anderweitige physikalische oder chemische Prozesse in Folge der Bearbeitung stattfinden, sodass der bearbeitete Teil der lithographisch bearbeitbaren Schicht entfernbar ist.

Bezogen auf den Verfahrensschritt d. sei angemerkt, dass das lithographische Abtragen der lithographisch bearbeitbaren Schicht sich auch auf die gesamte lithographisch bearbeitbare Schicht beziehen kann, d.h. die gesamte lithographisch bearbeitbare Schicht kann abgetragen werden. Die lithographisch bearbeitbare Auftragsmasse wird sodann im Schritt e. nicht nur in dem freigelegten ersten Teilbereich aufgebracht, sondern auch in jenen Bereichen, in welchen zuvor die lithographisch bearbeitbare Schicht (auch außerhalb des ersten Teilbereichs) abgetragen wurde. Der freigelegte erste Teilbereich der Substratoberfläche hat vorzugsweise eine im Wesentlichen kreisförmige Kontur. Es kann jedoch vorgesehen sein, dass das Abtragen der strahlungsundurchlässigen Schicht in dem in Richtung der ersten Substratoberfläche an den ersten Abtragungsbereich angrenzenden zweiten Abtragungsbereich durch einen Abtragungsprozess erfolgt, welcher isotrop in alle Raumrichtungen wirkt. Entsprechend kann die geformte Lochöffnung über die Schichtdicke der strahlungsundurchlässigen Schicht einen größeren Durchmesser aufweisen als im Bereich der ausgebildeten Lochöffnung im Bereich der lithographisch bearbeitbaren Schicht.

Wie erwähnt, wird verfahrensgemäß (Schritt g.) ausgehend von dem freigelegten zweiten Teilbereich der Substratoberfläche das transparente Substrats in einem Substrat-Abtragungsbereich zur Ausbildung einer zylindrischen Lochöffnung abgetragen, wobei die Lochöffnung in ihrer lateralen Ausdehnung dem zweiten Teilbereich entspricht und sich in Richtung der zweiten Substratoberfläche über eine Teildicke des transparenten Substrats erstreckt. Die Lochöffnung schließt sich fluchtend an den zweiten Teilbereich an und ist konzentrisch zum ersten Teilbereich angeordnet.

Nachfolgend seien vorteilhafte Ausgestaltungen des erfindungsgemäßen Verfahrens angegeben. In diesem Zusammenhang seien auch die in den Unteransprüchen angegebenen vorteilhaften Ausgestaltungen beschrieben.

Nach einer ersten Ausgestaltung des erfindungsgemäßen Verfahrens kann vorgesehen sein, dass ein Glassubstrat als transparentes Substrat verwendet wird. Transparenz bedeutet in diesem Zusammenhang, dass jede Strahlung, z.B. Laserstrahlung, die von der zu erzeugenden Lochblende in einem optischen Aufbau (z.B. einer Laserbearbeitungsvorrichtung) räumlich gefiltert und/oder geformt werden soll, durch das Glassubstrat hindurchtreten kann. Das Glassubstrat kann beispielsweise eine planparallele Glasplatte sein. Die Glasplatte kann beispielsweise eine Polygonform (Dreieck, Viereck in Form eines Rechtecks oder Quadrats), eine Kreisform (Scheibenform), eine ovale Form, eine elliptische Form aufweisen.

Nach einer weiteren Ausgestaltung des erfindungsgemäßen Verfahrens kann vorgesehen sein, dass die strahlungsundurchlässige Schicht zumindest ein Metall oder eine Metallverbindung umfasst, wobei das Metall insbesondere Chrom ist oder die Metallverbindung eine Chromverbindung ist, und dass die strahlungsundurchlässige Schicht im Schritt b. im Wege einer Elektronenstrahlverdampfung auf der ersten Substratoberfläche abgeschieden wird. Alternativ oder zusätzlich kann die strahlungsundurchlässige Schicht Nickel und/oder Wolfram umfassen. Alternativ oder zusätzlich kann vorgesehen sein, dass die strahlungsundurchlässige Schicht eine Nickel- und/oder Wolframverbindung umfasst. Bei einer "Metallverbindung" kann es sich um ein Metallsalz, eine Metalllegierung, eine intermetallische Phase oder dergleichen handeln. Grundsätzlich kann die strahlungsundurchlässige Schicht aus jedem Material oder jeder Materialkombination (z.B. verschiedene Metalle, Metallverbindungen oder dergleichen) gebildet werden, solange die Strahlungsundurchlässigkeit für die Strahlung gewünschter Wellenlänge gewährleistet ist.

Nach einer weiteren Ausgestaltung des erfindungsgemäßen Verfahrens kann vorgesehen sein, dass die im Schritt c. aufgetragene lithographisch bearbeitbare Schicht eine Lackschicht ist, insbesondere eine Positivlackschicht ist, und dass die lithographisch bearbeitbare Schicht im Anschluss an die Auftragung gehärtet wird. Die Auftragung der lithographisch bearbeitbaren Schicht kann beispielsweise im Wege eines "Spin-Coating" Verfahrens erfolgen. Auch ein "Spray-Coating" ist vorstellbar. Unter einem Positivlack kann insbesondere ein Photolack verstanden werden, dessen Löslichkeit im Wege einer photochemischen Reaktion sich durch entsprechende Belichtung erhöht. Bei dem Photolack kann es sich z.B. um einen 900 nm UV6 Lack handeln. Die Härtung der lithographisch bearbeitbaren Schicht kann im Wege einer Trocknung (z.B. einer Trocknung an Luft, einer Trocknung unter Zuhilfenahme einer Wärme- oder Strahlungsquelle), einer chemischen Härtung durch Bestrahlen (Photopolymerisation) einer Lösungsmittelverdampfung etc. erfolgen.

Nach einer weiteren Ausgestaltung des erfindungsgemäßen Verfahrens kann vorgesehen sein, dass das lithographische Abtragen der lithographisch bearbeitbaren Schicht im Schritt d. im Wege einer Elektronenstrahllithographie, einer optischen Lithographie oder durch direktes Laserschreiben erfolgt. Das Verfahren der optischen Lithographie kann beispielsweise auch auf UV-Strahlung basieren. Laserstrahlung kann z.B. durch Halbleiterlaser, Festkörperlaser oder Excimer-Laser erzeugt werden. Durch Applikation einer der genannten Methoden (Elektronenstrahllithographie, optische Lithographie, direktes Laserschreiben) wird die Löslichkeit, der im vorangehenden Schritts aufgetragenen lithographisch bearbeitbare Schicht, erhöht, wodurch sich diese in einfacher Weise entfernen lässt. Die so angelöste Schicht kann beispielsweise mechanisch entfernt werden. Auch ein einfaches Herausspülen der angelösten Schicht ist möglich.

Nach einer weiteren Ausgestaltung des erfindungsgemäßen Verfahrens kann vorgesehen sein, dass das Abtragen der strahlungsundurchlässigen Schicht im Schritt d. im Wege eines Ätzverfahrens erfolgt. Dabei kann es sich insbesondere um ein nasschemisches Ätzverfahren handeln (z.B. unter Verwendung einer Chromätzlösung). Dabei handelt es sich um ein isotropes Ätzverfahren, welches die strahlungsundurchlässige Schicht in sämtliche Raumrichtungen abträgt. Das Maß des "Wegätzens" der strahlungsundurchlässigen Schicht kann durch die Ätz-Dauer, die Art und Konzentration der Ätzlösung eingestellt werden. In Richtung der ersten Substratoberfläche wird die strahlungsundurchlässige Schicht in dem zweiten Abtragungsbereich vollständig bis zur ersten Substratoberfläche abgetragen, sodass diese freigelegt ist. Aufgrund des isotropen Ätzens weist der zweite Abtragungsbereich in lateral eine größere Ausdehnung (einen größeren Durchmesser) auf als der erste Abtragungsbereich.

Nach einer weiteren Ausgestaltung des erfindungsgemäßen Verfahrens kann vorgesehen sein, dass die im Schritt e. aufgebrachte lithographisch bearbeitbare Auftragsmasse eine Lackmasse ist, insbesondere eine Positivlackmasse ist, und dass die Auftragsmasse im Anschluss an die Aufbringung gehärtet wird. Auch die Positivlackmasse kann einen Photolack umfassen, beispielsweise einen 900 nm PMMA 950k A6 Lack. Die lithographisch bearbeitbare Auftragsmasse wird insbesondere in dem ersten und zweiten Abtragungsbereich aufgetragen. Jedoch kann die lithographisch bearbeitbare Auftragsmasse bei einer Verfahrensführung, bei welcher die lithographisch bearbeitbare Schicht zuvor vollständig entfernt wurde, auch in jenen Bereichen aufgetragen werden, in welchen die lithographisch bearbeitbare Schicht zuvor aufgebracht wurde, also auf der strahlungsundurchlässigen Schicht. Jegliches Auftragungsverfahren, das zum Auftragen einer Lackschicht (z.B. Spin-Coating, Spray-Coating etc.) kann verfahrensgemäß zum Auftragen der lithographisch bearbeitbaren Auftragsmasse eingesetzt werden. Die Härtung der lithographisch bearbeitbaren Auftragsmasse kann im Wege einer Trocknung (z.B. einer Trocknung an Luft, einer Trocknung unter Zuhilfenahme einer Wärme- oder Strahlungsquelle), einer chemischen Härtung durch Bestrahlen (Photopolymerisation) einer Lösungsmittelverdampfung etc. erfolgen.

Nach einer weiteren Ausgestaltung des erfindungsgemäßen Verfahrens kann vorgesehen sein, dass das lithographische Abtragen der lithographisch bearbeitbaren Auftragsmasse im Schritt f. im Wege einer Elektronenstrahllithographie, einer optischen Lithographie oder durch direktes Laserschreiben erfolgt. Wie erwähnt, kann das Verfahren der optischen Lithographie kann beispielsweise auch auf UV-Strahlung basieren. Laserstrahlung kann z.B. durch Halbleiterlaser, Festkörperlaser oder Excimer-Laser erzeugt werden. Durch Applikation einer der genannten Methoden (Elektronenstrahllithographie, optische Lithographie, direktes Laserschreiben) wird die Löslichkeit, der im vorangehenden Schritts aufgetragenen lithographisch bearbeitbaren Auftragsmasse, erhöht, wodurch sich diese in einfacher Weise entfernen lässt. Die so angelöste Schicht kann beispielsweise mechanisch entfernt werden. Auch ein einfaches Herausspülen der angelösten Schicht ist möglich.

Nach einer weiteren Ausgestaltung des erfindungsgemäßen Verfahrens kann vorgesehen sein, dass das Abtragen des transparenten Substrats im Schritt g. im Wege eines Ätzverfahrens, insbesondere eines Trockenätzverfahrens, erfolgt. Trockenätzverfahren lassen sich häufig besser steuern als Nassätzverfahren (Stichwort: isotropes Ätzen beim Nassätzverfahren). Für das Ätzverfahren werden die eingesetzten Stoffe bzw. die Verfahrensführung so gewählt, dass ein Teil des Glassubstrats (über eine vorgegebene Schichtdicke) entfernt (herausgeätzt) werden kann.

Nach einer weiteren Ausgestaltung des erfindungsgemäßen Verfahrens kann vorgesehen sein, dass das Entfernen der Reste der lithographisch bearbeitbaren Schicht und/oder der lithographisch bearbeitbaren Auftragsmasse im Schritt h. unter Einsatz eines Lösungsmittels erfolgt. Beispielsweise kann dazu ein organisches Lösungsmittel wie Alkohol (z.B. Isopropanol) eingesetzt werden. Auch andere Reinigungsverfahren zur Entfernung der Reste sind denkbar.

Wie erwähnt, wird die der Erfindung zugrunde liegende Aufgabe nebst dem Verfahren auch durch eine Lochblende gelöst, wobei die Lochblende nach einem erfindungsgemäßen Verfahren hergestellt ist. Die mit der Erfindung vorgeschlagene Lochblende ist - wie erwähnt - zur Strahlformung und/oder zur räumlichen Filterung von Strahlung, insbesondere Laserstrahlung, geeignet.

Die Lochblende umfasst:
a. ein transparentes Substrat mit einer ersten Substratoberfläche und einer der ersten Substratoberfläche gegenüberliegenden zweiten Substratoberfläche,
b. eine auf der ersten Substratoberfläche abgeschiedene strahlungsundurchlässige Schicht, und
c. eine sich ausgehend von der ersten Substratoberfläche in Richtung der zweiten Substratoberfläche über eine Teildicke des Substrats erstreckende zylindrische Lochöffnung,
wobei die erste Substratoberfläche in einem an die Lochöffnung angrenzenden Lochöffnungs-Angrenzungsbereich freiliegt und unbeschichtet ist.

Der genannte Lochöffnungs-Angrenzungsbereich bildet eine weitere Lochöffnung (insbesondere zylindrischer Form) aus, die bezogen auf eine senkrecht zur Substratebene verlaufende Achse einen größeren Innenradius aufweist als die im Substrat ausgebildete zylindrische Lochöffnung. Die weitere Lochöffnung verläuft durch die strahlungsundurchlässige Schicht und mündet in die zylindrische Lochöffnung des Substrats. Zwischen der im Substrat ausgebildeten zylindrischen Lochöffnung und der diese Lochöffnung umgebenden weiteren Lochöffnung ist eine konzentrisch verlaufende Stufe ausgebildet. Der Lochöffnungs-Angrenzungsbereich ist bezogen auf die Lochöffnung konzentrisch angeordnet ist.

Es ist auch denkbar die beschriebene (erfindungsgemäße) Lochblende mit einem abweichend zum erfindungsgemäßen Verfahren abweichenden Herstellungsverfahren zu fertigen.

Wie erwähnt, wird die der Erfindung zugrunde liegende Aufgabe nebst dem Verfahren und der Lochblende auch durch Anordnung aus einer Mehrzahl von Lochblenden zu einem Lochblenden-Array gelöst. Die Anordnung zeichnet sich dadurch aus, dass zumindest ein Teil der Mehrzahl von Lochblenden eine Lochöffnung und einen Lochöffnungs-Angrenzungsbereich mit voneinander abweichendem Durchmesser und/oder einer voneinander abweichenden Form aufweist. Dies kann sich sowohl auf die im Glassubstrat ausgebildete Lochöffnung sowie die an diese Lochöffnung angrenzende weitere Lochöffnung (diese ist im Bereich der undurchlässigen Schicht ausgebildet und mündet in die im Glassubstrat ausgebildete Lochöffnung). Die Mehrzahl von Lochblenden kann in einer einzelnen Zeile oder Spalte (d.h. in horizontaler oder vertikaler Parallelanordnung) oder matrixartig in mehreren Zeilen und/oder Spalten angeordnet sein. Die Lochblenden können einen äquidistanten Abstand zueinander aufweisen. Je nach Applikation oder gewünschter Betriebsparameter, können mit einem solchen Lochblenden-Array flexibel unterschiedliche Strahlformungs- oder räumliche Strahlfilterparameter eingestellt werden. Der Lochblenden-Array kann im Sinne einer Lochblenden-Wechseleinheit verstanden werden. In einem entsprechenden Aufbau kann zwischen unterschiedlichen Lochblenden des Lochblenden-Arrays manuell oder mechanisch (auch elektromechanisch) gewechselt werden. Die Lochblenden können somit in den Strahlengang ein- bzw. ausgeblendet werden. Die Lochblenden können wie erwähnt (z.B. in einer Zeile oder Spalte) in ihrer Form (z.B. kreisrund, elliptisch) und Durchmesser variieren. Auch kann damit der Durchmesser homogen auf einem Werkstück auszuleuchtenden Fläche schnell an eine sich ändernde Größe oder Form eines zu bearbeitenden Werkstücks angepasst werden. Der Lochblenden-Array ermöglicht eine flexible und schnelle Anpassung an die jeweilige Bearbeitungsaufgabe.

Ferner betrifft die Erfindung eine Verwendung einer erfindungsgemäßen Lochblende oder einer Anordnung einer Mehrzahl von Lochblenden in einem optischen Aufbau, insbesondere einem Interferometrie- oder Holographie-Aufbau.

Bei dem Interferometrie-Aufbau kann es sich um einen Laserinterferenzlithographie-Aufbau handeln, der aufweist: eine Laserstrahlungsquelle, einen Strahlteiler zur Teilung eines von der Laserstrahlungsquelle erzeugten Laserstrahls in zumindest zwei Teilstrahlen, die entlang eines jeweiligen Teilstrahlpfades in Richtung eines zu bearbeitenden Werkstücks verlaufen, wobei in jedem der Teilstrahlengänge zwischen dem Strahlteiler und dem Werkstück eine Lochblende oder eine Lochblenden-Anordnung angeordnet ist, und wobei die jeweiligen Teilstrahlen durch die jeweilige Lochblende oder Lochblenden-Anordnung hindurchtreten. Weitere optische Elemente wie Spiegel, Linsen oder dergleichen können in den jeweiligen Teilstrahlpfaden zusätzlich vorgesehen sein.

Die durch eine erfindungsgemäße Lochblende erzielbare gleichzeitige räumliche Filterung (Eliminierung von Speckles = zufällige Beugungsmuster) und Homogenisierung des Strahlquerschnitts in Freistrahlaufbauten, ist für zahlreiche Anwendungen wie beispielsweise die Holographie und Interferometrie vorteilhaft. Prinzipiell adressiert die erfindungsgemäße Lochblende alle Anwendungsgebiete, die eine kohärente und Speckles-freie, homogene Ausleuchtung erfordern.

So wird z.B. mittels Interferometrie die Belastung (Verformung) von hochbeanspruchten Bauteilen vermessen, indem Streifensysteme, die durch kohärente Überlagerung von Laserstrahlen entstehen, mathematisch ausgewertet werden. Verminderte Randbeleuchtung schränkt die Größe der Messfläche ein, oder kann zu Problemen bei der automatischen Auswertung führen.

Holographische Aufnahmen, die auf einer Photoplatte gespeichert wurden, oder holographische Projektionen zur Darstellung von Bildern in der dritten Dimension, haben oft den Nachteil, dass sie mit Speckles überlagert sind. Diese zufälligen Beugungsmuster entstehen im kohärenten Licht durch die Überlagerung von hochfrequenten Laseranteilen, die aufgrund von Streuung an Partikeln entstehen, die sich auf Oberflächen von optischen Elementen, wie Linsen, Filtern, Spiegeln, Polarisatoren, Wellenplatten oder auch Prismen befinden.

Wenn eine erfindungsgemäße Lochblende (oder ein Lochblenden-Array) eingesetzt wird, kann die genannte (ungewünschte) Überlagerung durch Tiefpassfilterung eliminiert werden. Gleichzeitig kann damit eine größere, homogen ausgeleuchtete Fläche zur Verfügung gestellt werden.

Wird bei der Laserinterferenzlithographie (LIL) ein Wafer unter einem bestimmten Winkel beleuchtet, kommt es aufgrund der Projektion auf die schräge Oberfläche zu einer elliptischen Verzerrung des Intensitätsprofils, was zur Folge hat, dass ein (z.B. kreisrunder) Wafer nicht deckungsgleich beleuchtet wird. Der Wafer stellt ein zu bearbeitendes Werkstück bereit. Durch entsprechende elliptische Vorverzerrung einer erfindungsgemäßen Lochblende kann dieser negative Effekt ausgeglichen werden.

Insbesondere ist der Homogenisierungseffekt für die LIL zur Herstellung von großflächigen Gitterwellenleiterstrukturen vorteilhaft. Die Effizienz dieser optischen Elemente ist mit einer definierten Strukturbreite verknüpft, die über die gesamte aktive Fläche der Elemente konstant sein soll.

Mittels LIL lassen sich schnell und kostengünstig großflächig periodische Strukturen, insbesondere Gitter, mit höchster Präzision herstellen. Die LIL basiert auf der Interferenz zweier per Strahlteiler aus einem Laserstrahl erzeugten Strahlarme (Teilstrahlen).

Wird ein Werkstück, beispielsweise ein in der Halbleiterindustrie gebräuchlicher Silizium-Wafer, mit einem für die Wellenlänge des verwendeten Lasers empfindlichen Photolack beschichtet und in den Bereich der interferierenden Teilstrahlen eingebracht, wird das Interferenzmuster in diesen Photolack übertragen. Im Zuge eines nachfolgenden Entwicklungsschritts, ähnlich dem Entwickeln konventionellen Filmmaterials, können somit Teile des Photolacks chemisch entfernt werden. Die so erzeugte, das Interferenzmuster wiederspiegelnde Photolackmaske, kann dann nachfolgend für eine Strukturübertragung mittels trocken- oder nasschemischem oder mittels dem sog. "lift-off"-Ver-fahren verwendet werden.

Bei Nutzung konventioneller Lochblenden weisen beide Teilstrahlen ein gaußförmiges Strahlprofil auf, die Strahlintensität fällt vom Mittelpunkt der Belichtung ausgehend rasch ab. Das Abfallen der Strahlintensität führt dazu, dass so erzeugte periodische Gitterstrukturen von der Mitte der Belichtung zum Rand eines zu prozessierenden Werkstücks hin veränderte Füllfaktoren aufweisen, bei einem Liniengitter ändert sich beispielsweise die Linienbreite. Die Nutzung von erfindungsgemäßen Lochblenden homogenisiert das einhüllende gaußförmige Strahlprofil und verspricht somit eine gleichmäßigere Ausleuchtung der Werkstückoberfläche und damit unmittelbar eine deutliche Reduktion dieser Füllfaktorvariationen.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird. In dieser Zeichnung zeigen schematisch:
- Fig. 1a,b: Darstellungen eines aus dem Stand der Technik bekannten Verfahrensablaufs zur Fertigung einer Lochblende,
- Fig. 1c: Darstellung einer Lochblende nach der Erfindung;
- Fig. 2a-i: Darstellungen eines mit der Erfindung vorgeschlagenen Verfahrens zur Fertigung einer erfindungsgemäßen Lochblende,
- Fig. 3: Darstellung eines Laserinterferenzlithographie-Aufbaus, in welchem eine erfindungsgemäße Lochblende oder eine erfindungsgemäße Anordnung einer Mehrzahl von Lochblenden zum Einsatz kommen kann;

In den Figuren 1a und 1b ist das aus der Publikation *"Modifed pinhole spatial filter producing a clean flat-topped beam", in Optics & Laser Technology, by P. Hariharan, Andal Narayanan, 2003"* bekannte Fertigungsverfahren einer zur räumlichen Filterung und/oder Strahlformung geeigneten Lochblende wiedergegeben.

Eine solche Lochblende kann in einem zweistufigen Fertigungsprozess hergestellt werden. Zunächst (vgl. Fig. 1a) wird dazu eine opake Metallfolie 1 auf einem Substrat 2 aufgebracht, wobei eine Öffnung 3 (bzw. Materialausnehmung) in die Metallfolie 1 hineingeätzt wird. Die Öffnung 3 kennzeichnet sich durch einen Radius r in Bezug auf eine sich zentriert entlang der Öffnung 3 erstreckende Achse A. Die Achse A erstreckt sich senkrecht zur Substratebene 4. In einem zweiten Schritt wird ein transparenter Film 5 einer Schichtdicke d auf das Substrat (bzw. die opake Metallfolie 1) aufgebracht. In den transparenten Film 5 wird eine in Bezug auf die erwähnte Achse A konzentrische Öffnung 6 geätzt, wobei die Öffnung 6 des transparenten Films 5 einen Radius r_{M} aufweist, der geringer ist als der Radius r. Bei geeigneter Wahl der Durchmesser r und r_{M}, und einer angepassten Schichtdicke d des transparenten Films, zeigt die Beugungsfigur in der Belichtungsebene einen starken Homogenisierungseffekt, siehe Abb. 3 der dortigen Publikation.

In der Fig. 1c ist eine nach der Erfindung hergestellte Lochblende wiedergegeben, die sich dasselbe physikalische Prinzip wie die Lochblende nach den Figuren 1a, 1b zu Nutze macht.

Die Lochblende umfasst ein transparentes Substrat 100 mit einer ersten Substratoberfläche 101 und einer der ersten Substratoberfläche 101 gegenüberliegenden zweiten Substratoberfläche 102. Auf der ersten Substratoberfläche 101 ist eine strahlungsundurchlässige Schicht 103 abgeschieden. Ausgehend von der ersten Substratoberfläche 101 erstreckt sich in Richtung der zweiten Substratoberfläche 102 über eine Teildicke w des Substrats 100 eine zylindrische Lochöffnung 104 mit einem Innenradius r₁. Die erste Substratoberfläche 101 liegt in einem an die Lochöffnung 104 angrenzenden Lochöffnungs-Angrenzungsbereich 105 frei und ist dort unbeschichtet.

Der genannte Lochöffnungs-Angrenzungsbereich 105 bildet eine weitere Lochöffnung 106 (insbesondere zylindrischer Form) aus, die bezogen auf eine senkrecht zur Substratebene E verlaufende Achse A einen größeren Innenradius r₂ aufweist als die im Substrat 100 ausgebildete zylindrische Lochöffnung 104. Zwischen der im Substrat 100 ausgebildeten zylindrischen Lochöffnung 104 und der in diese Lochöffnung 104 mündenden weiteren Lochöffnung 106 ist eine konzentrisch verlaufende Stufe 107 ausgebildet.

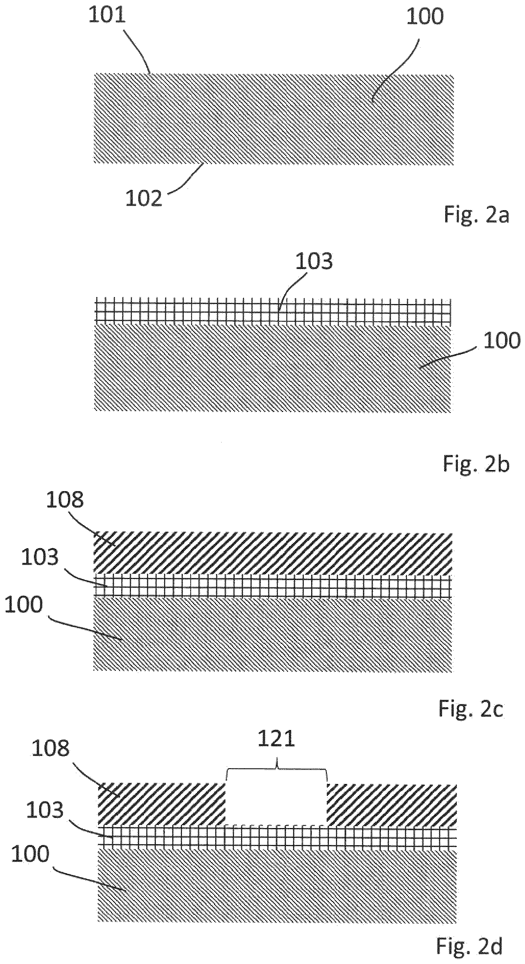

In den Figuren 2a bis 2i ist das erfindungsgemäße Herstellungsverfahren einer erfindungsgemäßen Lochblende schematisch illustriert. Vor der Fertigung sind die geometrischen Randbedingungen der herzustellenden Lochblende r₁, r₂ in Abhängigkeit der Wellenlänge des für jeweilige Anwendung, z.B. eines im Rahmen des LIL Verfahrens verwendeten Lasers und der gewünschten Größe der möglichst homogen auszuleuchtenden Fläche (des Werkstücks) zu bestimmen. Bei einer exemplarischen Laserwellenlänge von 266 nm, einem Glassubstrat mit einem Brechungsindex von 1,5 und dem Ziel die Fläche eines 6"-Siliziumwafers gleichmäßig belichten zu können, erweist sich eine erfindungsgemäße Lochblende mit einem Blendendurchmesser von 3,9 um und einem Verhältnis r₁/r₂ von 0,75-0,8 als zielführend. Vorzugsweise beträgt die Tiefe der Lochblende 266 nm, die sich aus der Teildicke w der Lochöffnung 104 und der Dicke h der Lochöffnung 106 zusammensetzt.

Wie in der Fig. 2a gezeigt, wird in einem ersten Verfahrensschritt ein transparentes Substrats 100 bereitgestellt, insbesondere ein Glassubstrat, bereitgestellt. Das transparente Substrat 100 weist eine erste Substratoberfläche 101 und eine der ersten Substratoberfläche 101 gegenüberliegende zweite Substratoberfläche 102 auf.

In einem zweiten Verfahrensschritt (Fig. 2b) wird eine strahlungsundurchlässige Schicht 103 auf der ersten Substratoberfläche 101 abgeschieden. Vorzugsweise handelt es sich bei der strahlungsundurchlässigen Schicht 103 um eine Chromschicht, die mittels Elektronenstrahlverdampfen abgeschieden wird.

Darauffolgend wird in einem weiteren Verfahrensschritt (Fig. 2c) eine lithographisch bearbeitbare Schicht 108 auf der strahlungsundurchlässigen Schicht 103 aufgetragen. Bei der lithographisch bearbeitbaren Schicht 108 handelt es sich um einen Photolack (900 nm UV6), der inklusive eines Post-Application Bake Schritts (2 min bei 130°C) appliziert wird. Die Applikation erfolgt vorzugsweise im Wege eines Spin-Coating Verfahrens.

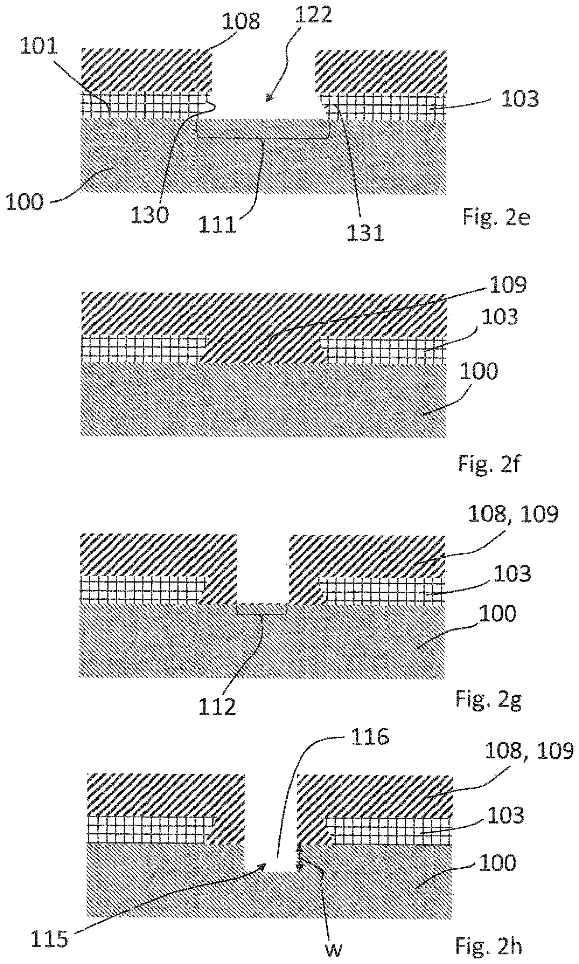

Sodann (Figuren 2d, e) wird ein erster Teilbereich 111 der ersten Substratoberfläche 101 partiell freigelegt. Zunächst wird dazu in einem ersten Abtragungsbereich 121 die lithographisch bearbeitbare Schicht 108 lithographisch abgetragen (Fig. 2d). Dies erfolgt inklusive eines Post -Exposure Bake Schritts sowie dem zugehörigen Entwicklungsprozess. Beispielsweise wird ein Verfahren der Elektronenstrahllithographie mit einer Raith EBPG 5200 Anlage bei 100 kV Beschleunigungsspannung eingesetzt. Der Post-Exposure Bake Schritt erfolgt bei 130°C für einen Zeitraum von 90 s. Die Entwicklung erfolgt mit einem MF 26A Entwickler für 45 s. Darauffolgend (vgl. Fig. 2e) wird die strahlungsundurchlässige Schicht 103 in einem in Richtung der ersten Substratoberfläche 101 an den ersten Abtragungsbereich 121 angrenzenden zweiten Abtragungsbereich 122 abgetragen. Dies erfolgt beispielsweise durch nasschemisches Ätzen mit einer Chromätzlösung für 5 min. Alternativ ist auch ein trockenchemisches Ätzen denkbar. Das nasschemische Ätzen erfolgt isotrop in alle Raumrichtungen, weshalb auch lateral ein Teil der strahlungsundurchlässigen Schicht 103 entfernt wird (vgl. die Anschrägungen 130, 131).

In einem nächsten Schritt (Fig. 2f) wird eine lithographisch bearbeitbare Auftragsmasse 109 in dem freigelegten ersten Teilbereich 111 aufgebracht. Auch kann vorgesehen sein, zuvor die lithographisch bearbeitbare Schicht 103 vollständig zu entfernen, und die lithographisch bearbeitbare Auftragsmasse wie in der Fig. 2f dargestellt auf den ersten Teilbereich 111 und eine Oberfläche der strahlungsundurchlässigen Schicht 103 aufzubringen. Die Auftragsmasse 109 ist ein Photolack (Positivlack), der inklusive Post Application Bake appliziert wird. Es kann ein 900 nm PMMA 950k A6 Photolack appliziert werden, wobei das Post Application Bake Prozedere für 10 min bei 180°C durchgeführt wird.

Sodann erfolgt in einem weiteren Schritt (vgl. Fig. 2g) ein partielles Freilegen eines zweiten Teilbereichs 112 der ersten Substratoberfläche 101, wobei der zweite Teilbereich 112 bezogen auf eine mit der ersten Substratoberfläche 101 zusammenfallende Substratebene E innerhalb eines gedachten ersten Teilbereichs 111 liegt (also einen geringeren Durchmesser aufweist), wobei das Freilegen durch teilweises lithographisches Abtragen der lithographisch bearbeitbaren Auftragsmasse 109 erfolgt. Dazu wird das Verfahren der Elektronenstrahllithographie inkl. Entwicklungsprozess eingesetzt (hier: Elektronenstrahllithographie mit einer Raith EBPG 5200-Anlage bei 100 kV Beschleunigungsspannung; Entwicklung mit einer 7:3 Mischung aus Isopropanol und Wasser für 45s).

Sodann wird das Verfahren mit dem folgenden Schritt fortgesetzt (illustriert in Fig. 2h): ausgehend von dem freigelegten zweiten Teilbereich 112 der ersten Substratoberfläche 101: Abtragen des transparenten Substrats 100 in einem Substrat-Abtragungsbereich 115 zur Ausbildung einer zylindrischen Lochöffnung 116, wobei die Lochöffnung 116 in ihrer lateralen Ausdehnung dem zweiten Teilbereich 112 entspricht und sich in Richtung der zweiten Substratoberfläche 102 über eine Teildicke w des transparenten Substrats 100 erstreckt. Die Abtragung des transparenten Substrats 100 erfolgt im Wege einer Trockenätzung, hier:
Trockenätzung mit einer Oxord Instruments PlasmaLab 100 ICP/RF - RIE Anlage mittels CHF3/Ar-basiertem Prozess.

In einem letzten Schritt (Fig. 2i) werden Reste der lithographisch bearbeitbaren Schicht 108 und/oder der lithographisch bearbeitbaren Auftragsmasse 109 entfernt (Reinigung). Dies kann beispielsweise mit einem Lösungsmittel wie Aceton (für einen Zeitraum von 5 min) und/oder Isopropanol (für 5 min) erfolgen. Fig. 2i zeigt zudem eine schematische Ansicht einer vollständig nach einem erfindungsgemäßen Verfahren gefertigten Lochblende.

In der Fig. 3 ist der eingangs beschriebene Laserinterferenzlithographie-Aufbau dargestellt, der eine Laserstrahlungsquelle 200, einen Strahlteiler 201 zur Teilung eines von der Laserstrahlungsquelle 200 erzeugten Laserstrahls 202 in zumindest zwei Teilstrahlen 202a, 202b, die entlang eines jeweiligen Teilstrahlpfades in Richtung eines zu bearbeitenden Werkstücks 210 verlaufen, wobei in jedem der Teilstrahlengänge zwischen dem Strahlteiler 201 und dem Werkstück 210 eine Lochblende 300 oder eine Lochblenden-Anordnung 400 angeordnet ist, und wobei die jeweiligen Teilstrahlen 202a, 202b durch die jeweilige Lochblende 300 oder Lochblenden-Anordnung 400 hindurchtreten. Der Laserinterferenzlithographie-Aufbau kann noch weitere Komponenten beinhalten, wie Objektive 211 und Spiegel 212.

*Das zu dieser Patentanmeldung gehörige Projekt wurde gefördert, folgender Hinweis sei hierzu erlaubt:*

*"The project leading to this application has received funding from the European Union's Horizon 2020 research and innovation program under grant agreement No 813159 (GREAT)".*

### Bezugszeichenliste

- 1: Metallfolie
- 2: Substrat
- 3: Öffnung
- 4: Substratebene
- 5: transparenter Film
- 6: Öffnung
- 100: transparentes Substrat
- 101: erste Substratoberfläche
- 102: zweite Substratoberfläche
- 103: strahlungsundurchlässige Schicht
- 104: zylindrische Lochöffnung
- 105: Lochöffnungs-Angrenzungsbereich
- 106: Lochöffnung
- 107: Stufe
- 108: lithographisch bearbeitbare Schicht
- 109: lithographisch bearbeitbare Auftragsmasse
- 111: erster Teilbereich
- 112: zweiter Teilbereich
- 115: Substrat-Abtragungsbereich
- 121: erster Abtragungsbereich
- 122: zweiter Abtragungsbereich
- 130: Anschrägung
- 131: Anschrägung
- 200: Laserstrahlungsquelle
- 201: Strahlteiler
- 202: Laserstrahl
- 210: Werkstück
- 211: Objektiv
- 300: Lochblende
- 400: Lochblenden-Anordnung
- A: Achse
- d: Schichtdicke
- E: Substratebene
- h: Dicke
- r: Radius
- r₁: Innenradius
- r₂: Innenradius
- w: Teildicke

## Patentansprüche

1. Verfahren zur Herstellung einer Lochblende (300), die zur Strahlformung und/oder zur räumlichen Filterung von Strahlung, insbesondere Laserstrahlung, geeignet ist, umfassend die folgenden Schritte:
a. Bereitstellen eines transparenten Substrats (100), wobei das transparente Substrat (100) eine erste Substratoberfläche (101) und eine der ersten Substratoberfläche (101) gegenüberliegende zweite Substratoberfläche (102) aufweist;
b. Abscheiden einer strahlungsundurchlässigen Schicht (103) auf der ersten Substratoberfläche (101);
c. Auftragen einer lithographisch bearbeitbaren Schicht (108) auf der strahlungsundurchlässigen Schicht (103);
d. Partielles Freilegen eines ersten Teilbereichs (111) der ersten Substratoberfläche (101) durch
- Lithographisches Abtragen der lithographisch bearbeitbaren Schicht (108) in einem ersten Abtragungsbereich (121) und darauffolgendes
- Abtragen der strahlungsundurchlässigen Schicht (103) in einem in Richtung der ersten Substratoberfläche (101) an den ersten Abtragungsbereich (121) angrenzenden zweiten Abtragungsbereich (122);
e. Aufbringen einer lithographisch bearbeitbaren Auftragsmasse (109) in dem freigelegten ersten Teilbereich (111);
f. Partielles Freilegen eines zweiten Teilbereichs (112) der ersten Substratoberfläche (101), wobei der zweite Teilbereich (112) bezogen auf eine mit der ersten Substratoberfläche (101) zusammenfallende Substratebene (E) innerhalb eines gedachten ersten Teilbereichs (111) liegt, wobei das Freilegen durch teilweises lithographisches Abtragen der lithographisch bearbeitbaren Auftragsmasse (109) erfolgt;
g. Ausgehend von dem freigelegten zweiten Teilbereich (112) der ersten Substratoberfläche (101): Abtragen des transparenten Substrats (100) in einem Substrat-Abtragungsbereich (115) zur Ausbildung einer zylindrischen Lochöffnung (116), wobei die Lochöffnung (116) in ihrer lateralen Ausdehnung dem zweiten Teilbereich (112) entspricht und sich in Richtung der zweiten Substratoberfläche (102) über eine Teildicke (w) des transparenten Substrats (100) erstreckt;
h. Entfernen von Resten der lithographisch bearbeitbaren Schicht (108) und/oder der lithographisch bearbeitbaren Auftragsmasse (109).

2. Verfahren nach Anspruch 1, **dadurch gekennzeichnet, dass** ein Glassubstrat als transparentes Substrat (100) verwendet wird.

3. Verfahren nach Anspruch 1, **dadurch gekennzeichnet, dass** die strahlungsundurchlässige Schicht (103) zumindest ein Metall oder eine Metallverbindung umfasst, wobei das Metall insbesondere Chrom ist oder die Metallverbindung eine Chromverbindung ist, und dass die strahlungsundurchlässige Schicht (103) im Schritt b. im Wege einer Elektronenstrahlverdampfung auf der ersten Substratoberfläche (101) abgeschieden wird.

4. Verfahren nach Anspruch 1, **dadurch gekennzeichnet, dass** die im Schritt c. aufgetragene lithographisch bearbeitbare Schicht (108) eine Lackschicht ist, insbesondere eine Positivlackschicht ist, und dass die lithographisch bearbeitbare Schicht (108) im Anschluss an die Auftragung gehärtet wird.

5. Verfahren nach Anspruch 1, **dadurch gekennzeichnet, dass** das lithographische Abtragen der lithographisch bearbeitbaren Schicht (108) im Schritt d. im Wege einer Elektronenstrahllithographie, einer optischen Lithographie oder durch direktes Laserschreiben erfolgt.

6. Verfahren nach Anspruch 1, **dadurch gekennzeichnet, dass** das Abtragen der strahlungsundurchlässigen Schicht (103) im Schritt d. im Wege eines Ätzverfahrens erfolgt.

7. Verfahren nach Anspruch 1, **dadurch gekennzeichnet, dass** die im Schritt e. aufgebrachte lithographisch bearbeitbare Auftragsmasse (109) eine Lackmasse ist, insbesondere eine Positivlackmasse ist, und dass die Auftragsmasse (109) im Anschluss an die Aufbringung gehärtet wird.

8. Verfahren nach Anspruch 1, **dadurch gekennzeichnet, dass** das lithographische Abtragen der lithographisch bearbeitbaren Auftragsmasse (109) im Schritt f. im Wege einer Elektronenstrahllithographie, einer optischen Lithographie oder durch direktes Laserschreiben erfolgt.

9. Verfahren nach Anspruch 1, **dadurch gekennzeichnet, dass** das Abtragen des transparenten Substrats (100) im Schritt g. im Wege eines Ätzverfahrens, insbesondere eines Trockenätzverfahrens, erfolgt.

10. Verfahren nach Anspruch 1, **dadurch gekennzeichnet, dass** das Entfernen der Reste der lithographisch bearbeitbaren Schicht (108) und/oder der lithographisch bearbeitbaren Auftragsmasse (109) im Schritt h. unter Einsatz eines Lösungsmittels erfolgt.

11. Lochblende (300) hergestellt nach einem Verfahren gemäß einem der Ansprüche 1 bis 10, wobei die Lochblende (300) zur Strahlformung und/oder zur räumlichen Filterung von Strahlung, insbesondere Laserstrahlung, geeignet ist, umfassend
a. ein transparentes Substrat (100) mit einer ersten Substratoberfläche (101) und einer der ersten Substratoberfläche (101) gegenüberliegenden zweiten Substratoberfläche (102),
b. eine auf der ersten Substratoberfläche (101) abgeschiedene strahlungsundurchlässige Schicht (103), und
c. eine sich ausgehend von der ersten Substratoberfläche (101) in Richtung der zweiten Substratoberfläche (102) über eine Teildicke (w) des Substrats (100) erstreckende zylindrische Lochöffnung (104),
wobei die erste Substratoberfläche (101) in einem an die Lochöffnung (104) angrenzenden Lochöffnungs-Angrenzungsbereich (105) freiliegt und unbeschichtet ist.

12. Lochblende (300) nach Anspruch 11, **dadurch gekennzeichnet, dass** der Lochöffnungs-Angrenzungsbereich (105) bezogen auf die Lochöffnung (104) konzentrisch angeordnet ist.

13. Anordnung (400) aus einer Mehrzahl von Lochblenden (300) nach Anspruch 11, zu einem Lochblenden-Array, **dadurch gekennzeichnet, dass** zumindest ein Teil der Mehrzahl von Lochblenden (300) eine Lochöffnung (104) und einen Lochöffnungs-Angrenzungsbereich (105) mit voneinander abweichendem Durchmesser und/oder einer voneinander abweichenden Form aufweist.

14. Verwendung einer Lochblende (300) nach Anspruch 11 oder einer Anordnung (400) nach Anspruch 13 in einem optischen Aufbau, insbesondere einem Interferometrie- oder Holographie-Aufbau.

15. Verwendung nach Anspruch 14, wobei der Interferometrie-Aufbau ein Laserinterferenzlithographie-Aufbau ist, der eine Laserstrahlungsquelle (200), einen Strahlteiler (201) zur Teilung eines von der Laserstrahlungsquelle (200) erzeugten Laserstrahls (202) in zumindest zwei Teilstrahlen, die entlang eines jeweiligen Teilstrahlpfades in Richtung eines zu bearbeitenden Werkstücks (210) verlaufen, wobei in jedem der Teilstrahlengänge zwischen dem Strahlteiler (201) und dem Werkstück (210) eine Lochblende (300) oder eine Lochblenden-Anordnung (400) angeordnet ist, und wobei die jeweiligen Teilstrahlen (201a. 201b) durch die jeweilige Lochblende (300) oder Lochblenden-Anordnung (400) hindurchtreten.
